# EUROPÄISCHE PATENTSCHRIFT

(11) **EP 0 483 199 B1**
(45) Veröffentlichungstag und Bekanntmachung des Hinweises auf die Patenterteilung: **25.01.1995**
(21) Anmeldenummer: 90910733.6
(22) Anmeldetag: 04.07.1990
(51) Int. Cl.: C23C 4/18, H01L 39/24

(54) **VERFAHREN ZUR HERSTELLUNG OXIDKERAMISCHER FORMKÖRPER DURCH THERMISCHES SPRITZEN**
PROCESS FOR PRODUCING OXIDE CERAMIC MOULDED BODIES BY THERMAL SPRAYING
PROCEDE DE FABRICATION DE CORPS MOULES EN CERAMIQUE OXYDEE PAR PISTOLAGE THERMIQUE

(30) Priorität: 12.07.1989 DE 3923008
(43) Veröffentlichungstag der Anmeldung: 06.05.1992
(73) Patentinhaber: HOECHST AKTIENGESELLSCHAFT, 65926 Frankfurt am Main (DE)
(72) Erfinder: MORACH, Eugen, D-6237 Liederbach (DE); SCHINDLER, Hubert, D-6237 Liederbach (DE); SCHWARZ, Martin, D-6240 Königstein (DE); JÜNGER, Sabine, D-6237 Liederbach (DE)
(86) Internationale Anmeldenummer: EP9001068
(87) Internationale Veröffentlichungsnummer: WO9100934

(56) Entgegenhaltungen:
- EP-A- 0 288 711
- EP-A- 0 302 506
- GB-A- 518 884
- US-A- 2 281 225
- Technische Rundschau, Bd. 80, Nr. 12, 18. März 1988, Bern, CH; "Keramik aus dem Plasmastrahl", Seite 15
- Applied Physics A, Solids and Surfaces, Bd. A48, 1989, Springer-Verlag, Heidelberg, DE; J. KARTHIKEYAN et al.: "Effect of process parameters on the properties of plasmasprayed superconducting Y1Ba2Cu3O7-x coatings", Seiten 489-492
- Applied Physics Letters, Bd. 52, , Nr. 12, 21. März 1988, American Institute of Physics, New York, N.Y., US; K. TACHIKAWA et al.: "High Tc superconducting films of Y-Ba-Cu oxides prepared by low-pressure plasma spraying", Seiten 1011-1013

## Beschreibung

Die Erfindung betrifft ein Verfahren zur Herstellung oxidkeramischer Formkörper durch thermisches Spritzen eines oxidkeramischen Materials auf eine formgebende Oberfläche.

Zur Herstellung spezieller Formkörper in geringeren Stückzahlen wird eine Schicht oxidkeramischen Materials durch thermisches Spritzen auf ein Trägermaterial, aufgebracht und das Trägermaterial z.B. durch Auflösen oder Ätzen anschließend entfernt, um den Formkörper zu erhalten. Diese Verfahren sind nicht nur aufwendig, sondern bei speziellen oxidkeramischen Materialien, wie supraleitenden Materialien, ungeeignet, da letztere feuchtigkeitsempfindlich sind.

Beim thermischen Spritzen wird eine auf dem Trägermaterial fest haftende Schicht erhalten. Bei Verwendung von oxidkeramischen supraleitenden Materialien wird die auf dem Trägermaterial aufgebrachte oxidkeramische Schicht anschließend einer thermischen Nachbehandlung unterzogen, die zur Erzeugung supraleitender Eigenschaften bzw. zur Verbesserung der supraleitenden Eigenschaften notwendig ist und längere Zeit dauert. Da die verwendeten Trägermaterialien, z.B. Al₂O₃, ZrO₂, MgO, Si, sich chemisch nicht inert verhalten, kommt es bei der thermischen Nachbehandlung infolge des engen Kontaktes zwischen Trägermaterial und Schicht zu einer Schädigung der Supraleiterschichten, d.h. die Sprungtemperatur T_{c} und die kritische Stromdichte I_{c} wird kleiner.

Werden nicht dünnschichtige Formkörper sondern dickere Formkörper hergestellt, so werden diese Formkörper in der Regel gepreßt und anschließend gesintert oder heiß-isostatisch gepreßt. Diese Formgebungsverfahren haben einige Nachteile. Insbesondere das Heiß-Isostatische Pressen ist aufwendig und kostenintensiv. Beim Kalt-Pressen müssen den oxidkeramischen Materialien organische Bindemittel zugesetzt werden, damit der Grünkörper eine ausreichende Festigkeit hat. Diese Bindemittel müssen beim anschließenden Sinterverfahren wieder ganz entweichen, was infolge der bei der Zusetzung der Bindemittel entstehenden Gasentwicklung zu einer Gefügeverschlechterung (geringe Dichte, hohe Porösität, Risse u.s.w.) führen kann. Werden bei diesen Verfahren oxidkeramische supraleitende Materialien verwendet, treten weitere Nachteile auf. Durch den Kohlenstoffgehalt der Bindemittel finden beim Sintern, wenn sich das Bindemittel zersetzt, Nebenreaktionen mit den supraleitenden Materialien statt. Dadurch bilden sich unerwünschte Korngrenzen und Fremdphasen ohne supraleitende Eigenschaften aus, was zu einer Verschlechterung der Eigenschaften der hergestellten Formkörper führt.

Aufgabe der vorliegenden Erfindung ist es, ein Verfahren der eingangs genannten Art zu schaffen, mit dem sich sowohl dünnschichtige als auch massive Formkörper mit guten Gefügeeigenschaften weniger aufwendig herstellen lassen. Bei Verwendung supraleitender Materialien sollen sich Formkörper mit verbesserten supraleitenden Eigenschaften herstellen lassen.

Diese Aufgabe wird durch das im Patentanspruch 1 angegebene Verfahren gelöst.

Als thermische Spritzverfahren kommen vorwiegend das Flamm- und Plasmaspritzen mit den in DIN 32530 (Entwurf Okt. 1987) aufgeführten Varianten zum Einsatz.

Die formgebende Oberfläche dient während des thermischen Spritzens als Trägermaterial für die Spritzschicht aus oxidkeramischen Material. Die formgebende Oberfläche weist die gewünschte Form des herzustellenden Formkörpers auf. Sie kann eben ausgebildet und dabei eine beliebige Form haben, z.B. ring- oder kreisförmig, rechteckig u.s.w. Sie kann ferner gewölbt sein, z.B. tiegel- oder schalenförmig. Sie kann aber auch beliebig andere Formen aufweisen, z.B. rohrförmig u.s.w.

Die formgebende Oberfläche besteht aus einem Werkstoff, der mit den oxidkeramischen Materialien bei den Bedingungen des thermischen Spritzens nicht reagiert. Ferner muß der Werkstoff einen thermischen Ausdehnungskoeffizienten haben, der von dem des oxidkeramischen Materials deutlich abweicht. Vorzugsweise ist der thermische Ausdehnungskoeffizient des Werkstoffs der formgebenden Oberfläche um mindestens den Faktor 1,5 größer oder kleiner als der thermische Ausdehnungskoeffizient des oxidkeramischen Materials ist. Als Werkstoffe kommen z.B. Metalle wie Kupfer und Aluminium, und Kunststoffe in Frage. Grundsätzlich kann jeder Werkstoff verwendet werden, der die beiden genannten Bedingungen erfüllt.

Die formgebende Oberfläche wird während der Beschichtung von innen z.B. mit Wasser gekühlt, damit keine zu starke Haftung des aufgespritzten oxidkeramischen Materials auf der formgebenden Oberfläche infolge zu hoher Temperaturen entsteht. Vorzugsweise wird die formgebende Oberfläche auf Temperaturen im Bereich von 60 bis 90°C gekühlt. Nach der abgeschlossenen Beschichtung wird die beschichtete formgebende Oberfläche abgeschreckt, um die Beschichtung als Formkörper von der formgebenden Oberfläche zu lösen. Vorzugsweise wird mit einer Rate von mindestens 40°C/s abgeschreckt, wozu flüssiger Stickstoff verwendet werden kann.

Der Formkörper läßt sich durch das Abschrecken besonders gut lösen, wenn die formgebende Oberfläche eine bestimmte Rauhigkeit aufweist. Eine glatte Oberfläche ergibt zwar eine gute Ablösung, gewährleistet jedoch nicht immer, daß die Schicht während des thermischen Spritzens gleichmäßig auf der formgebenden Oberfläche haftet. Andererseits sollte die formgebende Oberfläche nicht zu rauh sein, damit keine zu intensive Verzahnung zwischen Beschichtung und formgebender Oberfläche entsteht. Vorzugsweise weist die formgebende Oberfläche eine durchschnittliche Oberflächenrauhigkeit von 10 bis 40 »m auf und besonders bevorzugt von 15 bis 30 »m. Bei einer bevorzugten Ausführungsform wird die formgebende Oberfläche zunächst aufgerauht, z.B. durch Sandstrahlen, und anschließend geschliffen, z.B. mit Schmirgelpapier, wobei die Spitzen der Erhebungen teilweise abgetragen und abgerundet werden.

Da sich dickere Schichten nicht so gut ablösen lassen, wird die formgebende Oberfläche vorzugsweise mit einer bis etwa 1 mm dicken Schicht des oxidkeramischen Materials beschichtet. Soll der Formkörper dicker sein, so kann er nach dem Ablösen von der formgebenden Oberfläche in eine Halterung eingespannt werden und durch weiteres thermisches Spritzen mit einer oder mehreren Schichten aus oxidkeramischen Material bis zur gewünschten Formkörperdicke versehen werden, wobei während des Aufbringens der weiteren Schicht bzw. Schichten der Formkörper mit z.B. Druckluft oder Kohlendioxidgas gekühlt wird.

Das erfindungsgemäße Verfahren ist für alle oxidkeramischen Materialien verwendbar. Es bietet den Vorteil, daß sich die Formkörper nach dem thermischen Spritzen von der formgebenden Oberfläche abtrennen lassen, ohne daß die formgebende Oberfläche durch Auflösen oder andere Maßnahmen verloren geht und die Formkörper beschädigt werden. Gegenüber den zur Herstellung dickerer Formkörper angewandten Preßverfahren ist das erfindungsgemäße Verfahren einfacher und führt zu Formkörpern mit besserem Gefüge. Das erfindungsgemäße Verfahren ist insbesondere zur Herstellung von Formkörpern aus oxidkeramischen supraleitenden Materialien geeignet, wie z.B. La_{1,8}Ba_{0,2}CuO₄, La_{1,8}Sr_{0,2}CuO₄ , Ba₂MCu₃O₇₋ₓ (M=Y oder Seltenerdmetalle außer Ce, Pr und Nd, O≦x≦1), Bi-Sr-Ca-Cu-O oder Tl-Ba-Ca-Cu-O. Bei Einsatz supraleitender Materialien weist das erfindungsgemäße Verfahren zusätzliche Vorteile auf. Durch die Ablösung des Formkörpers von der formgebenden Oberfläche kann die zur Erzeugung oder Verbesserung der supruleitenden Eigenschaften notwendige thermische Nachbehandlung ohne Beeinträchtigung der supraleitenden Eigenschaften durchgeführt werden. Wie eingangs bereits ausgeführt wurde, treten solche Beeinträchtigungen auf, wenn die supraleitende Schicht fest auf einem Trägermaterial haftet. Die erfindungsgemäß hergestellten Formkörper können zur thermischen Nachbehandlung dagegen lose auf einer Unterlage liegen oder an einigen Stellen abgestützt werden. Hierbei treten keine Risse auf, die bei einer starren Verbindung zwischen supraleitender Schicht und Trägermaterial infolge der unterschiedlichen thermischen Ausdehnung von Trägermaterial und supraleitender Schicht verursacht werden. Außerdem werden störende Reaktionen zwischen Trägermaterial und Formkörper, die zu einer Verschlechterung der supraleitenden Eigenschaften führen, weitgehend oder vollständig vermieden. Gegenüber der Formgebung durch Pressen weist das erfindungsgemäße Verfahren den Vorteil auf, daß keine Bindemittel in dem Formkörper enthalten sind, die zu Nebenreaktionen und damit zu einer Verschlechterung der supraleitenden Eigenschaften führen können.

Der von der formgebenden Oberfläche abgelöste Formkörper kann beliebig weiter behandelt werden. Bei der zur Erzeugung oder Verbesserung der supraleitenden Eigenschaften notwendigen thermischen Nachbehandlung wird der Formkörper in Sauerstoffatmosphäre bis zu einer Temperatur aufgeheizt, bei der Sauerstoff aufgenommen wird. Anschließend wird der Formkörper langsam in Sauerstoffatmosphäre abgekühlt.

Die Erfindung wird an Hand der Ausführungsbeispiele näher erläutert.

### Beispiel 1

Oxidkeramisches Pulver YBa₂Cu₃O₇₋ₓ wurde unter für das Plasmaspritzen normalen Bedingungen auf eine Kupferplatte gespritzt. Die Kupferplatte war vorher sandgestrahlt und geschliffen worden und wies eine durchschnittliche Oberflächenrauhigkeit von 20 »m auf. Die Rauheitsspitzen wiesen eine abgerundete Form auf. Während des Spritzens wurde die Kupferplatte mit Wasser auf 70 bis 80 °C von innen gekühlt. Nachdem die Spritzschicht eine Dicke von 1 mm erreicht hatte, wurde die Kupferplatte mit flüssigem Stickstoff abgechreckt. Die Spritzschicht ließ sich leicht vollständig von der Kupferplatte ablösen.

### Beispiel 2

Die Verfahrensweise von Beispiel 1 wurde wiederholt mit der Ausnahme, daß als oxidkeramisches Pulver Bi₂Sr₂CaCu₂Oₓ verwendet wurde. Die Spritzschicht ließ sich nach dem Abschrecken leicht von der Kupferplatte ablösen.

## Patentansprüche

1. Verfahren zur Herstellung oxidkeramischer Formkörper durch thermisches Spritzen eines oxidkeramischen Materials auf eine formgebende Oberfläche, dadurch gekennzeichnet, daß die formgebende Oberfläche aus einem mit dem oxidkeramischen Material nicht reagierenden Werkstoff besteht, dieser Werkstoff einen thermischen Ausdehnungskoeffizienten aufweist, der von dem thermischen Ausdehnungskoeffizienten des aufgespritzten oxidkeramischen Materials verschieden ist, die formgebende Oberfläche während der Beschichtung gekühlt wird und die fertig beschichtete formgebende Oberfläche abgeschreckt wird, wodurch sich die Beschichtung als Formkörper von der formgebenden Oberfläche ablösen läßt.

2. Verfahren nach Anspruch 1, dadurch gekennzeichnet, daß der thermische Ausdehnungskoeffizient des Werkstoffs der formgebenden Oberfläche um mindestens den Faktor 1,5 von dem des aufgespritzten oxidkeramischen Materials abweicht.

3. Verfahren nach Anspruch 1 oder 2, dadurch gekennzeichnet, daß die beschichtete formgebende Oberfläche mit einer Rate von mindestens 40°C/s abgeschreckt wird.

4. Verfahren nach einem der Ansprüche 1 bis 3, dadurch gekennzeichnet, daß die formgebende Oberfläche eine durchschnittliche Oberflächenrauhigkeit von 10 bis 40 »m aufweist.

5. Verfahren nach Anspruch 4, dadurch gekennzeichnet, daß die durchschnittliche Oberflächenrauhigkeit zwischen 15 und 30 »m liegt.

6. Verfahren nach einem der Ansprüche 1 bis 5, dadurch gekennzeichnet, daß die formgebende Oberfläche durch Aufrauhen und anschließendes Schleifen, wobei die Spitzen der Erhebungen abgerundet werden, vorbehandelt ist.

7. Verfahren nach einem der Ansprüche 1 bis 6, dadurch gekennzeichnet, daß die formgebende Oberfläche während der Beschichtung auf Temperaturen von 60 bis 90°C gekühlt wird.

8. Verfahren nach einem der Ansprüche 1 bis 7, dadurch gekennzeichnet, daß die beschichtete formgebende Oberfläche mit flüssigem Stickstoff abgeschreckt wird.

9. Verfahren nach einem der Ansprüche 1 bis 8, dadurch gekennzeichnet, daß die formgebende Oberfläche mit einer bis circa 1 mm dicken Schicht des oxidkeramischen Materials beschichtet wird.

10. Verfahren nach einem der Ansprüche 1 bis 9, dadurch gekennzeichnet, daß das oxidkeramische Material die Bruttozusammensetzung eines supraleitenden Materials aufweist.

11. Verfahren nach Anspruch 10, dadurch gekennzeichnet, daß das oxidkeramische Material Kupfer in oxidischer Form enthält.

12. Verfahren nach einem der Ansprüche 1 bis 11, dadurch gekennzeichnet, daß der von der formgebenden Oberfläche abgelöste Formkörper in eine Halterung eingespannt wird und durch weiteres thermisches Spritzen mit einer oder mehreren Schichten aus oxidkeramischen Material bis zur gewünschten Formkörperdicke versehen wird unter gleichzeitiger Kühlung des Formkörpers.

13. Verfahren nach einem der Ansprüche 1 bis 12, dadurch gekennzeichnet, daß die formgebende Oberfläche tiegel- oder schalenförmig ausgebildet ist.

14. Verfahren nach einem der Ansprüche 10 bis 13, dadurch gekennzeichnet, daß der von der formgebenden Oberfläche abgelöste und ggf. durch weiteres thermisches Spritzen beschichtete Formkörper in Sauerstoffatmosphäre bis zu einer Temperatur aufgeheizt wird, bei der Sauerstoff aufgenommen wird, wodurch die supraleitenden Eigenschaften hergestellt oder verbessert werden, und der Formkörper nach dem Aufheizen langsam in Sauerstoffatmosphäre abgekühlt wird.

15. Verfahren nach einem der Ansprüche 1 bis 14, dadurch gekennzeichnet, daß das oxidkeramische Material durch Flamm-oder Plasmaspritzen auf die formgebende Oberfläche aufgebracht wird.

## Claims

1. A process for producing oxide ceramic molded bodies by thermal spraying of an oxide ceramic material onto a molding surface, wherein the molding surface is composed of a material which does not react with the oxide ceramic material, said material has a coefficient of thermal expansion which is different from the coefficient of thermal expansion of the sprayed-on oxide ceramic material, the molding surface is cooled during the coating and the fully coated molding surface is quenched, as a result of which the coating can be detached as a molded body from the molding surface.

2. The process as claimed in claim 1, wherein the coefficient of thermal expansion of the material of the molding surface differs from that of the sprayed-on oxide ceramic material at least by a factor of 1.5.

3. The process as claimed in claim 1 or 2, wherein the coated molding surface is quenched at a rate of at least 40°C/s.

4. The process as claimed in one of claims 1 to 3, wherein the molding surface has an average peak-to-valley height of 10 to 40 »m.

5. The process as claimed in claim 4, wherein the average peak-to-valley height is between 15 and 30 »m.

6. The process as claimed in one of claims 1 to 5, wherein the molding surface is pretreated by roughening and subsequent grinding, the peaks of the projections being rounded off.

7. The process as claimed in one of claims 1 to 6, wherein the molding surface is cooled to temperatures of 60 to 90°C during the coating.

8. The process as claimed in one of claims 1 to 7, wherein the coated molding surface is quenched with liquid nitrogen.

9. The process as claimed in one of claims 1 to 8, wherein the molding surface is coated with a layer of the oxide ceramic material up to approximately 1 mm thick.

10. The process as claimed in one of claims 1 to 9, wherein the oxide ceramic material has the overall composition of a superconducting material.

11. The process as claimed in claim 10, wherein the oxide ceramic material contains copper in oxide form.

12. The process as claimed in one of claims 1 to 11, wherein the molded body detached from the molding surface is clamped in a holding device and is provided with one or more layers of oxide ceramic material by further thermal spraying until the desired molded body thickness is reached, with simultaneous cooling of the molded body.

13. The process as claimed in one of claims 1 to 12, wherein the molding surface is of crucible-shaped or dish-shaped construction.

14. The process as claimed in one of claims 10 to 13, wherein the molded body detached from the molding surface and optionally coated by further thermal spraying is heated in an oxygen atmosphere to a temperature at which oxygen is absorbed, as a result of which the superconducting properties are produced or improved, and the molded body is slowly cooled in an oxygen atmosphere after the heating.

15. The process as claimed in one of claims 1 to 14, wherein the oxide ceramic material is applied to the molding surface by flame spraying or plasma-jet spraying.

## Revendications

1. Procédé pour la préparation de produits moulés en céramique oxydée par projection thermique de matériau céramique oxydée sur une surface de moulage, caractérisé en ce que la surface de moulage est constituée de matériau qui ne réagit pas avec le matériau céramique oxydée, ce matériau présente un coefficient de dilatation thermique qui est différent du coefficient de dilatation thermique du matériau céramique oxydée projeté, la surface de moulage est refroidie au cours des dépôts du revêtement, et on trempe la surface de moulage avec le revêtement fini, ce qui permet de détacher le revêtement, en tant que produit moulé de la surface de moulage.

2. Procédé selon la revendication 1, caractérisé en ce que le coefficient de dilatation thermique du matériau de la surface de moulage s'écarte d'un facteur d'au moins 1,5 de celui du matériau céramique oxydée projeté.

3. Procédé selon la revendication 1 ou 2, caractérisé en ce qu'on trempe la surface de moulage revêtue avec une vitesse d'au moins 40°C/s.

4. Procédé selon l'une des revendications 1 à 3, caractérisé en ce que la surface de moulage présente une rugosité superficielle moyenne de 10 à 40 »m.

5. Procédé la revendication 4, **caractérisé** en ce que la rugosité superficielle moyenne est comprise entre 15 et 30 »m.

6. Procédé selon l'une des revendications 1 à 5, caractérisé en ce que la surface de moulage est prétraitée par un procédé pour la rendre rugeuse et ensuite par polissage, en arrondissant alors les pics des aspérités.

7. Procédé selon l'une des revendications 1 à 6, caractérisé en ce que la surface de moulage est refroidie à une température de 60 à 90°C au cours du dépôt.

8. Procédé selon l'une des revendications 1 à 7, caractérisé en ce que la surface de moulage revêtue est trempée avec de l'azote liquide.

9. Procédé selon l'une des revendications 1 à 8, caractérisé en ce que la surface de moulage est revêtue d'une couche d'environ 1 mm de matériau céramique oxydée.

10. Procédé selon l'une des revendications 1 à 9, caractérisé en ce que le matériau céramique oxydée présente une composition brute d'un matériau supraconducteur.

11. Procédé selon la revendication 10, caractérisé en ce que le matériau céramique oxydée contient du cuivre sous forme d'oxyde.

12. Procédé selon l'une des revendications 1 à 11, caractérisé en ce que le produit moulé détaché de la surface de moulage est fixé sur un support et est muni par d'autres projections thermiques d'une ou de plusieurs couches de matériau céramique oxydée jusqu'à ce que l'épaisseur voulue de la paroi du produit moulé soit atteinte, tout en refroidissant simultanément le produit moulé.

13. Procédé selon l'une des revendications 1 à 12, caractérisé en ce que la surface de moulage a la forme de nacelle ou de coquille.

14. Procédé selon l'une des revendications 10 à 13, caractérisé en ce que le produit moulé détaché de la surface de moulage est éventuellement revêtu par projections thermiques supplémentaires et chauffé sous une atmosphère d'oxygène jusqu'à la température d'absorption de l'oxygène, ce qui permet d'induire ou d'améliorer les caractéristiques supraconductrices et d'après le chauffage, le produit moulé est refroidi lentement sous une atmosphère d'oxygène.

15. Procédé selon l'une des revendications 1 à 14, caractérisé en ce que le matériau céramique oxydée est déposé par projection à la flamme ou au plasma sur la surface de moulage.
